# EUROPEAN PATENT SPECIFICATION

(11) **EP 3 739 639 B1**
(45) Date of publication and mention of the grant of the patent: **13.11.2024**
(21) Application number: 19200644.3
(22) Date of filing: 30.09.2019
(51) Int. Cl.: H01L 31/05

(54) **METHOD OF PRODUCING OF A SOLAR CELL ASSEMBLY**
VERFAHREN ZUR HERSTELLUNG EINER SOLARZELLANORDNUNG
PROCÉDÉ DE PRODUCTION D'UN ENSEMBLE DE CELLULES SOLAIRES

(30) Priority: 13.05.2019 US 201916410904
(43) Date of publication of application: 18.11.2020
(73) Proprietor: SolAero Technologies Corp., Albuquerque, NM 87123 (US)
(72) Inventor: AIKEN, Daniel, Cedar Crest, NM 87008 (US); DERKACS, Daniel, Albuquerque, NM 87111 (US); MCPHEETERS, Claiborne, NM 87106 (US)
(74) Representative: Balder IP Law, S.L.

(56) References cited:
- US-A1- 2003 029 494
- US-A1- 2013 068 278
- US-A1- 2016 013 344
- US-A1- 2017 012 154
- US-A1- 2018 076 348
- US-A1- 2018 178 929
- US-A1- 2019 109 251
- US-B1- 9 444 004

## Description

### BACKGROUND OF THE DISCLOSURE

### 1. Field of the Disclosure

The disclosure relates to the field of photovoltaic power devices, and more particularly integral mosaic assemblies or CICs of discrete solar cell mosaic elements.

### 2. Description of the Related Art

Photovoltaic devices, such as photovoltaic modules or CIC (solar Cell + Interconnects + Cover glass) assemblies, comprise one or more individual solar cells arranged to produce electric power in response to irradiation by solar light. Sometimes, the individual solar cells are rectangular, often square. Photovoltaic modules, arrays and devices including one or more solar cells may also be substantially rectangular, for example, based on an array of individual solar cells. Arrays of substantially circular solar cells are known to involve the drawback of inefficient use of the surface on which the solar cells are mounted, due to space that is not covered by the circular solar cells that is left between adjacent solar cells due to their circular configuration (cf. U.S. Patents Nos. 4,235,643 and 4,321,417).

However, solar cells are often produced from circular or substantially circular wafers. For example, solar cells for space applications are typically multi-junction solar cells grown on substantially circular wafers. These circular wafers are typically 100 mm or 150 mm diameter wafers. However, as explained above, for assembly into a solar array (henceforth, also referred to as a solar cell assembly), substantially circular solar cells, which can be produced from substantially circular wafers to minimize wasting wafer material and, therefore, minimize solar cell cost, are often not the best option, due to their low array fill factor, which increases the overall cost of the photovoltaic array or panel and implies an inefficient use of available space. Therefore the circular wafers are often divided into other form factors to make solar cells. The preferable form factor for a solar cell for space is a rectangle, such as a square, which allows for the area of a rectangular panel consisting of an array of solar cells to be filled 100% (henceforth, that situation is referred to as a "fill factor" of 100%), assuming that there is no space between the adjacent rectangular solar cells. However, when a single circular wafer is divided into a single rectangle, the wafer utilization is low. This results in waste. This rectangular solar cell can then be placed side by side with other rectangular solar cells obtained from other wafers, thereby providing for efficient use of the surface on which the solar cells are placed (i.e., a high fill factor): a large W/m² ratio can be obtained, which depending on the substrate may also imply a high W/kg ratio, of great importance for space applications. That is, closely packed solar cells without any space between the adjacent solar cells is generally preferred, and especially for applications in which W/m² and/or W/kg are important aspects to consider. This includes space applications, such as solar power devices for satellites or space vehicles.

Space applications frequently use high efficiency solar cells, including multi-junction solar cells and/or III/V compound semiconductor solar cells. High efficiency solar cell wafers are often costly to produce. Thus, the waste that has conventionally been accepted in the art as the price to pay for a high fill factor, that is, the waste that is the result of cutting the rectangular solar cell out of the substantially circular solar cell wafer, can imply a considerable cost.

A solar cell designed for use in a space vehicle (such as a satellite, space station, or an interplanetary mission vehicle), has a sequence of subcells with compositions and band gaps which have been optimized to achieve maximum energy conversion efficiency for the AM0 solar spectrum in space. The AM0 solar spectrum in space is notably different from the AM1.5 solar spectrum at the surface of the earth, and accordingly terrestrial solar cells are designed with subcell band gaps optimized for the AM1.5 solar spectrum.

There are substantially more rigorous qualification and acceptance testing protocols used in the manufacture of space solar cells compared to terrestrial cells, to ensure that space solar cells can operate satisfactorily at the wide range of temperatures and temperature cycles encountered in space. These testing protocols include (i) hightemperature thermal vacuum bake-out; (ii) thermal cycling in vacuum (TVAC) or ambient pressure nitrogen atmosphere (APTC); and in some applications (iii) exposure to radiation equivalent to that which would be experienced in the space mission, and measuring the current and voltage produced by the cell and deriving cell performance data.

As used in this disclosure and claims, the term "space-qualified" shall mean that the electronic component (i.e., the solar cell) provides satisfactory operation under the high temperature and thermal cycling test protocols. The exemplary conditions for vacuum bake-out testing include exposure to a temperature of +100 °C to +135 °C (e.g., about +100 °C, +110 °C, +120 °C, +125 °C, +135 °C) for 2 hours to 24 hours, 48 hours, 72 hours, or 96 hours; and exemplary conditions for TVAC and/or APTC testing that include cycling between temperature extremes of -180°C (e.g., about -180 °C, -175 °C, -170 °C, -165 °C, -150 °C, -140 °C, -128 °C, -110°C, -100 °C, -75 °C, or -70 °C) to +145 °C (e.g., about +70 °C, +80 °C, +90 °C, +100 °C, +110 °C, +120 °C, +130 °C, +135 °C, or +145 °C) for 600 to 32,000 cycles (e.g., about 600, 700, 1500, 2000, 4000, 5000, 7500, 22000, 25000, or 32000 cycles), and in some space missions up to +180° C. See, for example, Fatemi et al., "Qualification and Production of Emcore ZTJ Solar Panels for Space Missions," Photovoltaic Specialists Conference (PVSC), 2013 IEEE 39th (DOI: 10. 1109/PVSC 2013 6745052). Such rigorous testing and qualifications are not generally applicable to terrestrial solar cells and solar cell arrays.

Conventionally, such measurements are made for the AM0 spectrum for "one-sun" illumination, but for PV systems which use optical concentration elements, such measurements may be made under concentrations such as 2x, 100x, or 1000x or more.

The space solar cells and arrays experience a variety of complex environments in space missions, including the vastly different illumination levels and temperatures seen during normal earth orbiting missions, as well as even more challenging environments for deep space missions, operating at different distances from the sun, such as at 0.7, 1.0 and 3.0AU (AU meaning astronomical units). The photovoltaic arrays also endure anomalous events from space environmental conditions, and unforeseen environmental interactions during exploration missions. Hence, electron and proton radiation exposure, collisions with space debris, and/or normal aging in the photovoltaic array and other systems could cause suboptimal operating conditions that degrade the overall power system performance, and may result in failures of one or more solar cells or array strings and consequent loss of power.

A further distinctive difference between space solar cell arrays and terrestrial solar cell arrays is that a space solar cell array utilizes welding and not soldering to provide robust electrical interconnections between the solar cells, while terrestrial solar cell arrays typically utilize solder for electrical interconnections. Welding is required in space solar cell arrays to provide the very robust electrical connections that can withstand the wide temperature ranges and temperature cycles encountered in space such as from -175° C to +180° C. In contrast, solder joints are typically sufficient to survive the rather narrow temperature ranges (e.g., about -40° C to about +50° C) encountered with terrestrial solar cell arrays.

A further distinctive difference between space solar cell arrays and terrestrial solar cell arrays is that a space solar cell array utilizes silver-plated metal material for interconnection members, while terrestrial solar cells typically utilize copper wire for interconnects. In some embodiments, the interconnection member can be, for example, a metal plate. Useful metals include, for example, molybdenum; a nickel-cobalt ferrous alloy material designed to be compatible with the thermal expansion characteristics of borosilicate glass such as that available under the trade designation KOVAR from Carpenter Technology Corporation; a nickel iron alloy material having a uniquely low coefficient of thermal expansion available under the trade designation Invar, FeNi36, or 64FeNi; or the like.

An additional distinctive difference between space solar cell arrays and terrestrial solar cell arrays is that space solar cell arrays typically utilize an aluminum honeycomb panel for a substrate or mounting platform. In some embodiments, the aluminum honeycomb panel may include a carbon composite face sheet adjoining the solar cell array. In some embodiments, the face sheet may have a coefficient of thermal expansion (CTE) that substantially matches the CTE of the bottom germanium (Ge) layer of the solar cell that is attached to the face sheet. Substantially matching the CTE of the face sheet with the CTE of the Ge layer of the solar cell can enable the array to withstand the wide temperature ranges encountered in space without the solar cells cracking, delaminating, or experiencing other defects. Such precautions are generally unnecessary in terrestrial applications.

A further distinctive difference of a space solar cell from a terrestrial solar cell is that the space solar cell must include a cover glass over the semiconductor device to provide radiation resistant shielding from particles in the space environment which could damage the semiconductor material. The cover glass is typically a ceria doped borosilicate glass which is typically from three to six mils in thickness and attached by a transparent adhesive to the solar cell.

In summary, it is evident that the differences in design, materials, and configurations between a space-qualified III-V compound semiconductor solar cell and subassemblies and arrays of such solar cells, on the one hand, and silicon solar cells or other photovoltaic devices used in terrestrial applications, on the other hand, are so substantial that prior teachings associated with a single silicon wafer into geometrical elements, and assembling them into an array for a terrestrial photovoltaic system are simply impractical and unsuitable for space applications, and thus such analogies have no applicability to the design configuration of space-qualified solar cells and arrays as set forth in the current disclosure. Indeed, the design and configuration of components adapted for terrestrial use with its modest temperature ranges and cycle times often teach away from the highly demanding design requirements for space-qualified solar cells and arrays and their associated components.

The assembly of individual solar cells together with electrical interconnects and the cover glass form a so-called "CIC" (Cell-Interconnect-Cover glass) assembly, which are then typically electrically connected to form an array of series-connected solar cells. The solar cells used in many arrays often have a substantial size; for example, in the case of the single standard substantially "square" solar cell trimmed from a 100 mm wafer with cropped corners, the solar cell can have a side length of seven cm or more.

Thus, the option of using substantially circular solar cells, corresponding to substantially circular solar cell wafers, to produce an array or assembly of solar cells, could in some cases become an interesting option. There is a trade-off between maximum use of the original wafer material and the fill factor.

US-2016/0013344-A1 discloses a method for producing solar cells comprising the step of dividing a non-rectangular solar cell wafer into a plurality of solar cells, the plurality of solar cells comprising at least one solar cell having a first geometric configuration, and at least one solar cell having a second geometric configuration, different from the first geometric configuration. The solar cells can have a rectangular shape and be rearranged and combined into a rectangular solar cell assembly.

US-2018/0178929-A1 discloses a space-qualified solar cell assembly comprising a plurality of space-qualified solar cells, each one of which being shaped as a portion of a circle, the portion having at least one curved edge having a shape of the arc of the circumference of the circle, and at least one straight edge, the portion having a surface area corresponding to not more than 50% of the surface area of the circle.

### SUMMARY OF THE DISCLOSURE

### Objects of the Disclosure

It is an object of the present disclosure to provide a method of fabricating a mosaic solar cell assembly by singulating a wafer into mosaic elements which maximizes both the utilization of the wafer area from which the mosaic elements are scribed, and the packing factor of the rearranged mosaic elements over a rectangular reference template.

It is another object of the present disclosure to provide a solar cell comprising a mosaic solar cell assembly which maximizes both the utilization of the wafer area from which the mosaic elements are scribed, and the packing factor of the rearranged mosaic elements over a rectangular reference template.

It is another object of the present disclosure to provide a mosaic solar cell assembly which is composed of a plurality of mosaic elements arranged longitudinally and adjacently over a rectangular reference template.

It is another object of the present invention to provide a plurality of mosaic solar cell elements linearly arranged with all interconnects disposed on one edge of the assembly.

It is another object of the present disclosure to provide a solar cell array comprising a plurality of rectangular mosaic solar cell assemblies each connected in a series electrical circuit by an interconnect extending over the upper long edge of one rectangular assembly and coupling to the lower long edge of an adjacent rectangular assembly.

It is another object of the present disclosure to provide a CIC building block for a photovoltaic panel including integrated under a single coverglass, interconnected with simple metal interconnect structures along one side of the CIC, and relying on adjacent CICs to complete the circuit, where the geometry and arrangement of constituent pieces, how well they tessellate and how they achieve the requirement above.

It is another object of the present disclosure of maximizing both the utilization of the wafer area from which the mosaic elements are scribed, and the packing factor of the rearranged mosaic elements over a rectangular reference template.

Some implementations of the present disclosure may incorporate or implement fewer of the aspects and features noted in the foregoing objects.

### Features of the Disclosure

The subject matter of the present invention is defined in claim 1. Some embodiments are defined in the dependent claims. All ranges of numerical parameters set forth in this disclosure are to be understood to encompass any and all subranges or "intermediate generalizations" subsumed herein. For example, a stated range of "1.0 to 2.0 eV" for a band gap value should be considered to include any and all subranges beginning with a minimum value of 1.0 eV or more and ending with a maximum value of 2.0 eV or less, e.g., 1.0 to 1.6, or 1.3 to 1.4, or 1.5 to 1.9 eV.

One aspect of the present disclosure is directed to the method of fabricating a mosaic solar cell assembly by scribing and singulating a substantially circular semiconductor solar cell wafer into a plurality of discrete polygonal or "mosaic" solar cells elements, and then rearranging, positioning and electrically connecting the elements in parallel as a closely packed "mosaic" solar cell assembly over the surface of a rectangularly shaped reference template. By utilizing a small number of mosaic elements, thereby minimizing the number and production cost of the placement of interconnect elements between the discrete mosaic elements, one can maximize both the area coverage of the solar cell elements over the template, and the utilization of the wafer surface area of the original solar cell wafer. Since the mosaic assembly has more active area over the surface of the square template than a single cropped-corner wafer would have, it provides greater efficiency in terms of the power density in W/m², or power per unit mass in W/kg, than previous approaches.

A first aspect relates to a method of producing a solar cell assembly comprising the steps of:
providing at least one solar cell wafer;
cutting each wafer into a plurality of mosaic elements (in the context of the present disclosure, the term "mosaic element" refers to a part of a wafer which can be combined with one or more other parts of the same wafer and/or with mosaic elements from other wafers to form the solar cell assembly);
arranging a plurality of the mosaic elements one after the other along a first axis, so that the mosaic elements form a row of mosaic elements, each mosaic element having substantially the same height in a direction perpendicular to the first axis (that is, the term "height" refers to the dimension of the mosaic element in a direction in the general plane of the solar cell assembly but perpendicularly to the first axis according to which the row is formed), each mosaic element having a first end at a first distance from the first axis and a second end at a second distance from the first axis (for example, both ends may be placed at the same absolute distance from the first axis but on different sides of the first axis), in the direction perpendicular to the first axis (that is, if the row of mosaic elements is inscribed in a rectangle, the first ends of the mosaic elements will be placed at one of the sides of the rectangle, and the second ends of the mosaic elements will be placed at the opposite side of the rectangle),
providing each mosaic element with a conductive interconnect at the first end thereof (for example, with an individual conductive interconnect at the first end of each individual mosaic element, or with a common conductive interconnect shared by a plurality of the mosaic elements, such as by all of the mosaic elements of the assembly; preferably the mosaic elements are provided with the interconnects only at the first ends thereof), so that the solar cell assembly can be electrically connected to an adjacent solar cell assembly;
and bonding the mosaic elements to a cover glass.

The steps do not necessarily have to be carried out in this specific order, but can be carried out in any order that makes technical sense. For example, the mosaic elements may be provided with the interconnects before or after being placed to form the row of mosaic elements.

The solar cell wafer is typically a circular or substantially circular solar cell wafer, for example, a solar cell waver having a generally circular configuration, with one or more cropped sides, that is, for example, with a straight side portion in correspondence with one or more chords of the general circular outline.

It has been found that this method is suitable to achieve a good balance between wafer utilization and array fill factor (that is, making efficient use of the available space), and that it is also efficient from a manufacture perspective, in that the assemblies made up of a plurality of mosaic elements and a cover glass support can be efficiently handled and mounted onto a further support when building a solar panel or array by joining and interconnecting a plurality of these mosaic solar cell assemblies, typically by interconnecting them in series using the interconnects. Thus, these kinds of solar cell assemblies can be useful as building blocks for solar panels, especially for space applications.

In many embodiments, the interconnects are provided only on one of the sides of each mosaic member.

In some embodiments, the present disclosure provides a method for producing a mosaic solar cell assembly, comprising the steps of providing a circular solar cell wafer; chamfering at least one diametrically opposed pair of sides of the wafer along two spaced apart portions of the circumference; cutting the wafer into four quadrants to form mosaic elements; providing a cover glass support; rearranging and positioning at least two mosaic elements adjacent to one another into a substantially rectangular mosaic assembly; providing a metal interconnect to each of the mosaic elements so that the mosaic elements may be electrically connected to an adjacent mosaic assembly; and bonding the cover glass support to the top of the mosaic assembly.

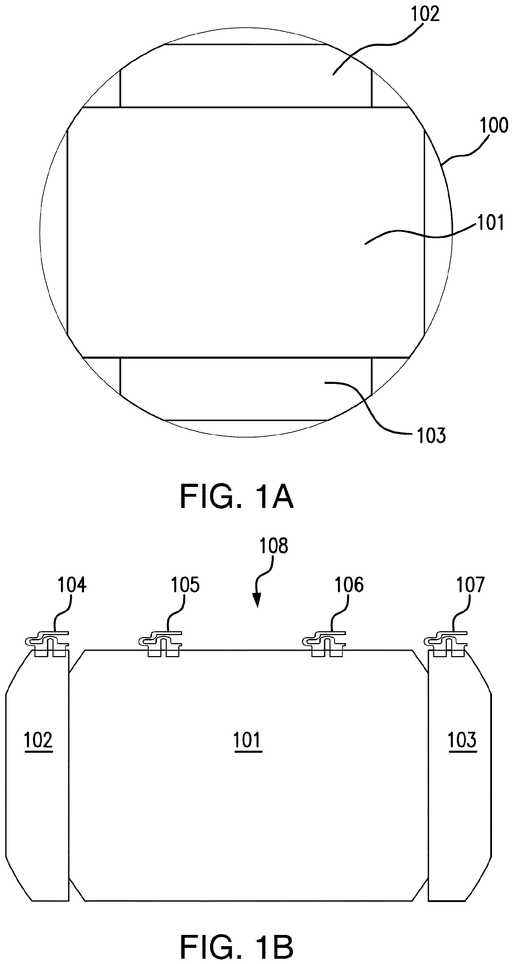

In some examples (not claimed), the present disclosure provides a method for producing a mosaic solar cell assembly, comprising the steps of providing a single cover glass support; singulating a III-V compound semiconductor solar cell wafer having a wafer surface area into three discrete solar cell mosaic elements, the solar cell mosaic elements comprising a first solar cell mosaic element and two second solar cell mosaic elements, wherein the first solar cell mosaic element has a surface area of between 60 and 70% of the wafer surface area, and each of the second solar cell mosaic element each has a surface area of between 8 and 12% of the wafer surface area; rearranging and positioning the three mosaic elements into a substantially rectangular mosaic assembly; providing a plurality of metal interconnects along the long edge of the mosaic assembly to allow an electrical interconnection between the mosaic elements so that the mosaic elements are may be electrically connected in series with a directly adjacent mosaic element disposed along the long edge; and bonding the single cover glass support to the top of the mosaic assembly. (See, e.g., FIG. 1B).

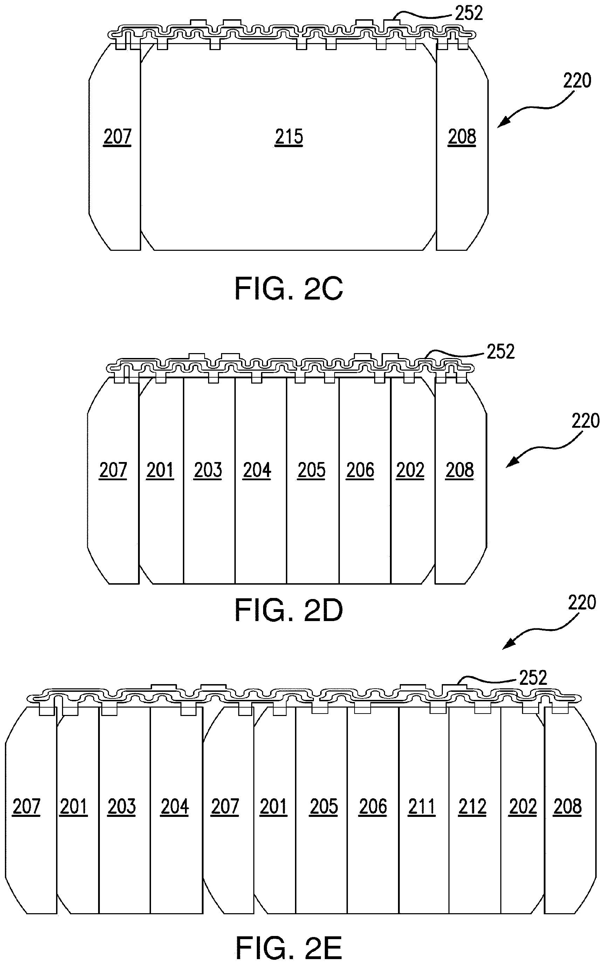

In some examples (not claimed), the present disclosure provides a method for producing a mosaic solar cell assembly, comprising the steps of providing a single cover glass support; singulating a III-V compound semiconductor solar cell wafer having a wafer surface area into three discrete solar cell mosaic elements, the solar cell mosaic elements comprising a first solar cell mosaic element and two second solar cell mosaic elements, wherein the first solar cell mosaic element has a surface area of between 60 and 70% of the wafer surface area, and each of the second solar cell mosaic element each has a surface area of between 8 and 12% of the wafer surface area; rearranging and positioning the three mosaic elements into a substantially rectangular mosaic assembly; providing a single metal interconnect along the long edge of the mosaic assembly and electrically connected to each mosaic element to allow an electrical interconnection between the mosaic solar cell assembly and a directly adjacent mosaic cell assembly disposed along the long edge; and bonding the single cover glass support to the top of the mosaic assembly. (See, e.g., FIG. 2C)

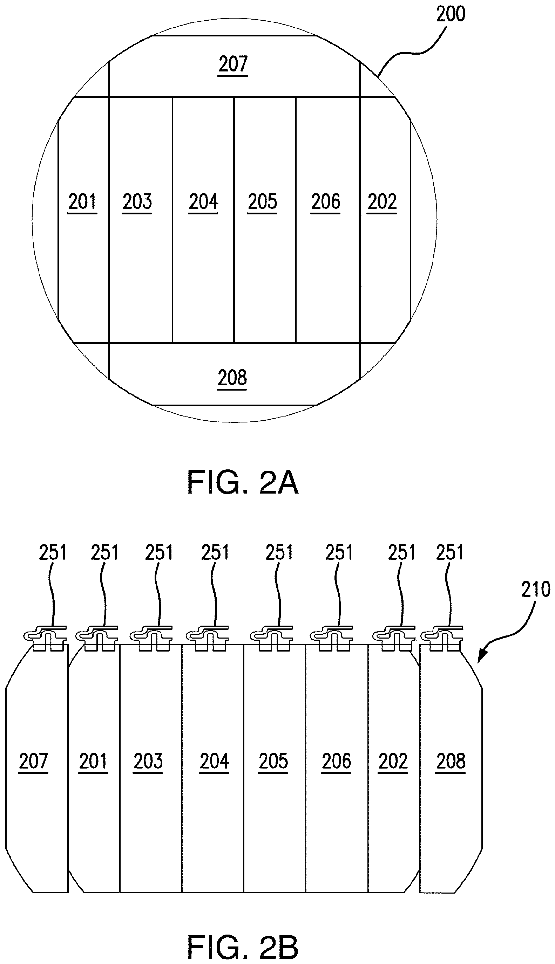

In some examples (not claimed), the present disclosure provides a method for producing a mosaic solar cell assembly, comprising the steps of providing a single cover glass support; singulating a III-V compound semiconductor solar cell wafer having a wafer surface area into a plurality of discrete solar cell mosaic elements, some being rectangular and some having a pair of two parallel straight edges on opposite sides of the wafer; rearranging and positioning the mosaic elements into a substantially rectangular mosaic assembly; providing one or more metal interconnects along the long edge of the mosaic assembly so that the mosaic elements may be electrically connected in series with a directly adjacent mosaic assembly disposed adjacent to the long edge; and bonding the single cover glass support to the top of the mosaic assembly. (See, e.g., FIG. 2B, 2D, 2E).

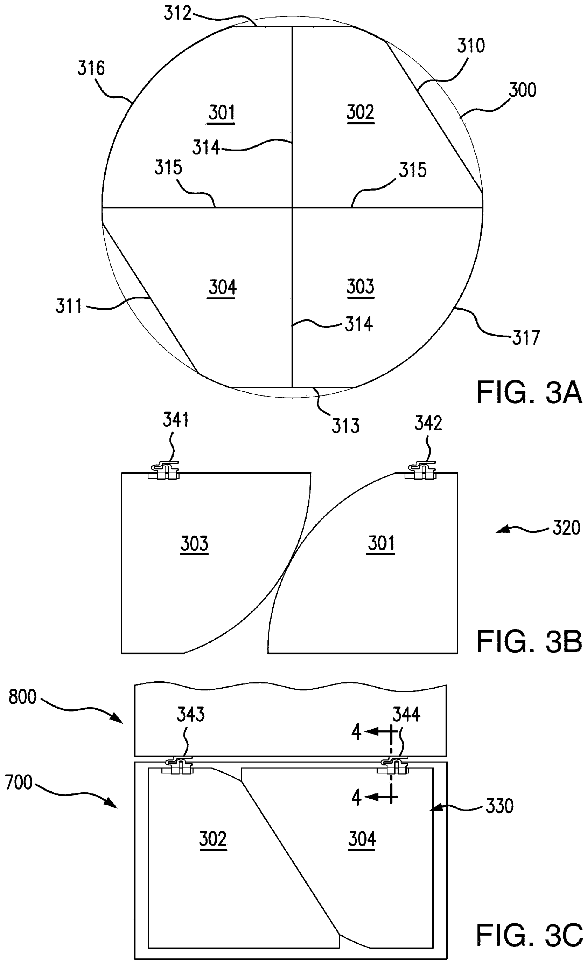

In some embodiments, the present disclosure provides a method for producing a mosaic solar cell assembly, comprising the steps of providing a single cover glass support; singulating a III-V compound semiconductor solar cell wafer having a wafer surface area into four discrete solar cell mosaic elements, each of the solar cell mosaic elements having two parallel straight edges, and a straight edge extending orthogonally to the two parallel straight edges; rearranging and positioning the mosaic elements into a substantially rectangular mosaic assembly; providing metal interconnects along the long edge of the mosaic assembly so that the mosaic elements may be electrically connected in series with a directly adjacent mosaic assembly disposed adjacent to the long edge; and bonding the single cover glass support to the top of the mosaic assembly. (See, e.g., FIG. 3A).

In some embodiments, the present disclosure provides a method for producing a mosaic solar cell, comprising the step of singulating a III-V compound semiconductor solar cell wafer having a wafer surface area into a plurality of discrete solar cell mosaic elements each having the same height (length) and width. (See, e.g., FIG. 2D, 2E)

In some embodiments, the present disclosure provides a solar cell assembly comprising: a cover glass support; a plurality of mosaic solar cell elements mounted on the support, wherein a first set of the plurality of the solar cell elements have an identical size and shape, and a second set of the plurality of solar cell elements have an identical second size and shape different from the first shape and all of the elements have the same height; and an interconnect mounted on one edge of each solar cell element, wherein all of the interconnects are arranged along one side of the solar cell assembly. (See, e.g., FIG. 2B, 2D, 2E).

In some embodiments, the present disclosure provides a solar cell assembly comprising: a cover glass support; a plurality of mosaic solar cell elements mounted on the support forming a rectangular reference template with each element having the same height and arranged serially along the length of the rectangular template, and an interconnect mounted on the upper edge of each solar cell element, so that the set of interconnects are arranged along a single elongated side of the solar cell assembly. (See, e.g., FIG. 2B).

In some embodiments, the present disclosure provides a solar cell assembly comprising: a cover glass support; a plurality of mosaic solar cell elements mounted on the support forming a rectangular reference template with each element having the same height and arranged serially along the length of the rectangular template, and a single interconnect mounted adjacent to the upper edge of each solar cell element and along one side of the solar cell assembly, and making contact with each of the mosaic solar cell elements. (See, e.g., FIG. 2C, 2D, 2E).

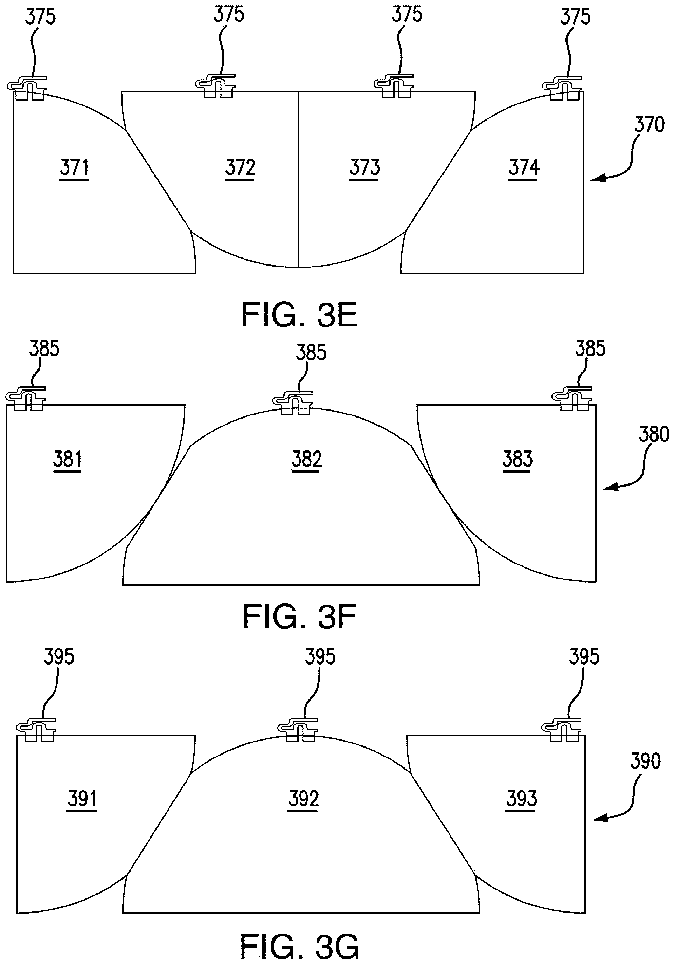

In some embodiments, the present disclosure provides a solar cell assembly comprising three or four mosaic solar cell elements, each solar cell element being shaped as a portion of a circle, the portion having at least one curved edge having a shape of an arc of the circle, the portion further having at least one straight edge, the portion having a surface area corresponding to not more than 50% of a surface area of the circle and not less than 25% of the surface area of the circle, the solar cell elements being arranged in a single row forming a rectangular assembly, wherein interconnects are provided along one long edge of the assembly to each of the mosaic elements. (See, e.g., FIG. 3E, 3F, 3G)

In some examples (not claimed), one mosaic solar cell element is shaped substantially as a semicircle. (See, e.g., FIG. 3F, 3G).

In some embodiments, each mosaic solar cell element has at least two straight edges. (See, e.g., FIG. 3E, 3F, 3G).

In some embodiments, the two straight edges are orthogonal, one of the two parallel straight edges being longer than the other one of the two parallel straight edges.

In another aspect, the present disclosure provides a solar cell array comprising: an array of individual CICs, with each CIC including a cover glass support; a plurality of mosaic solar cell elements mounted on the support forming a rectangular reference template with each element having the same height and arranged serially along the length of the rectangular template, and an interconnect mounted on the upper edge of each solar cell element so that the set of interconnects are arranged along one side of the solar cell assembly to enable the CIC to be serially connected with an adjacent CIC disposed over the long edge of the rectangular reference template. (See, e.g., FIG. 3C).

In some examples (not claimed) of the disclosure, the first solar cell mosaic element has a substantially polygonal shape with eight sides. (See, e.g., FIG. 2C).

In some examples (not claimed), the first solar cell mosaic element has two pairs of parallel edges that are orthogonal to each other and four cropped corners. (See, e.g., FIG. 2C).

In some embodiments, the CIC comprises two first, two second, and four third solar cell mosaic elements. (See, e.g., FIG. 2B and 2D).

In some embodiments, the CIC comprises three first, three second, and six third solar cell mosaic elements. (See, e.g., FIG. 2E).

In some embodiments, the corners of the mosaic element are not cropped and a formed by a portion of the circular peripheral edge of the wafer. (See, e.g. FIG. 2A, 201, 202, 207, 208)

In some examples (not claimed), the wafer is divided into eight solar cell mosaic elements. The use of a relatively small number of solar cell mosaic elements is preferred in order to minimize the number of interconnections in the subassembly, which takes up design space and adds to the cost of the assembly since each interconnection must be welded to each mosaic element and tested as part of the manufacturing procedure. (See, e.g., FIG. 2A).

In some embodiments, the solar cell wafer is a III-V compound semiconductor multijunction solar cell wafer. The relatively high cost of such a wafer material (which may be over 100 times the cost of a similarly sized silicon photovoltaic wafer) is an important motivating factor for the present disclosure, due to the reduction of waste of the wafer material without compromising packing factor and minimizing the number of interconnections.

In some embodiments, the solar cell mosaic elements are geometrically designed so as to be rearranged and positioned in the reference rectangle that will maximize the surface area coverage on a panel since rectangular elements are simple to stack and arrange. Thus, the elements are aligned so that their edges are quite close together and they are shaped as much as possible so as match in terms of fitting together covering a reference template area, which corresponds to the single cover glass support that provides the mechanical support for the elements.

In some embodiments, interconnects are provided along the long edge of the reference rectangle.

In some embodiments, the interconnects provided along the long edge of the reference rectangle are formed as a single discrete interconnect. (See, e.g. FIG. 2C, 2D, 2E).

In some embodiments, at least two interconnect pads are provided on the interconnect which make electrical contact with each of mosaic solar cell elements arranged along the long edge of the reference rectangle. (See, FIG. 2C).

Some embodiments relate to a method of obtaining a solar cell mosaic assembly, comprising the steps of: dividing a substantially circular solar cell wafer into a four solar cell mosaic elements. (See, e.g., FIG. 3A).

Some embodiments relate to a solar cell assembly comprising a plurality of solar cells, each of said plurality of solar cells being shaped as a portion, such as a sector or segment, of a substantially circular wafer, said portion having at least one curved edge having substantially the shape of an arc of the circumference of the circle and at least one straight edge, and having a surface area corresponding to not more than 50% of the surface area of the circle, that is, the total surface area, of the circle. That is, each of said plurality of solar cells has a shape corresponding to the one that is obtained by cutting a substantially circular wafer into at least two pieces, such as according to a sector or segment of the circle defined by the circumference of the substantially circular solar cell wafer.

It has been found that by dividing a substantially circular wafer into segments or, in some embodiments, sectors, solar cells are obtained that can be packed with a high fill factor while, at the same time, producing a rectangular unit cell, which is preferred in the case of the production of substantially rectangular solar cell assemblies. For example, a rectangular assembly can be appropriate, allowing the unit cells to be stacked vertically, simplifying interconnection. By using such an approach, wafer waste is minimized. Thus, by the division of the substantially circular wafer into portions such as segments or sectors, wafer utilization is maximized and at the same time a high fill factor is obtained in combination with a rectangular unit cell for the solar cell assembly. Thus, the disclosure provides for a flexible system that can often be advantageous to reach a good balance between the cost of the solar cell on the one hand and efficiency in terms of W/m² or W/kg of the solar cell assembly on the other hand. The disclosure may be especially useful and advantageous in the context of solar cells where the cost of the solar cell wafer is high, including many high efficiency solar cells, multi-junction solar cells and III/V compound semiconductor solar cells. It provides for relatively low wafer waste, while at the same time providing for a relatively high fill factor, which can also be important, for example, when the total space allowed for a solar panel, such as on a satellite, limits the maximum power that can be provided by the solar panel. The disclosure makes it possible to make use also of the material adjacent to the circumference of the circular wafer, without renouncing excessively on the fill factor and without renouncing on a rectangular unit cell. It has been found that it is possible to achieve >90% panel fill factor and to simultaneously achieve >90% wafer utilization, providing for a combined wafer and space utilization efficiency of >81%, if the mathematical product of the two aspects (panel fill factor and wafer utilization) is taken as a basis for calculating efficiency. Of course, in practice, it may be more important to enhance one of the two aspects than the other one, depending on issues such as the cost of wafer material and cost or availability of space.

In some embodiments of the disclosure, one portion of the solar cell corresponding to what was originally the circumference of the wafer may be chamfered to a flat portion. This is especially the case when the solar cells are obtained from a substantially circular wafer having a flat portion in correspondence with its circumference. When "circular wafers" or 'circles' are referred to herein, it is understood that in practice such shapes may be fully circular, but that the principles disclosed apply equally to substantially circular shapes or wafers, as are often used in practice.

In some embodiments of the disclosure, the curved edge of said plurality of solar cells has a length corresponding to at least 45 degrees, preferably at least 60 degrees, more preferably at least 90 degrees, of the circumference of the circle, and/or a size of at least 10%, preferably at least 25%, of the area of the circle. The use of relatively large solar cells can be useful to reduce the amount of work related to assembly and interconnections.

In some embodiments of the disclosure, said plurality of solar cells are substantially shaped as sectors of said circle. This option is often preferred, as it has been found practical to implement: it allows for full use of substantially all of the material of the substantially circular wafer and for the production of substantially identical solar cells which can then be assembled to form the array using the repetition of a simple basic pattern, without any need to accommodate a large number of differently shaped solar cells. The term "substantially" is used to encompass minor variants, such as the cases wherein there is one or more additional flat portions corresponding to the above-mentioned flat portion of the circumference present in many substantially circular wafers used for the production of solar cells.

In some embodiments of the disclosure, said plurality of solar cells comprises a plurality of solar cells substantially shaped as quadrants, that is, as quarters of a substantially circular wafer, with two straight edges at substantially 90 degrees to each other. A circular wafer can be split into four quadrants without substantial waste of material, and the use of quadrants has been found to be beneficial as the quadrants can be fitted into rectangular unit cells with a high fill factor, in the order of 90% or greater than 90%. Of course, a circular wafer can be split into smaller sectors which can, for example, be interconnected to form a quadrant, but this may at least sometimes be inefficient as interconnection implies additional costs. Thus, in many embodiments of the disclosure, it can be preferred to use only quadrants, or at least a substantial number and/or proportion of quadrants.

In some examples (not claimed) of the disclosure, said plurality of solar cells comprises a plurality of solar cells substantially shaped as semicircles. Semicircles may be less attractive than quadrants in what concerns flexibility and/or fill factor, but can nevertheless be used in embodiments of the disclosure.

In some examples (not claimed) of the disclosure, said plurality of solar cell mosaic elements comprises two solar cell mosaic elements shaped as quadrants and a solar cell mosaic element shaped as a semicircle. For example, in some embodiments of the disclosure, a semicircle and two quadrants can be combined into a unit cell. The use of one semicircle instead of two quadrants can serve to limit the number of interconnections. (See, e.g. FIG. 3F, 3G).

In some embodiments of the disclosure, a plurality of the solar cells are arranged so that a straight edge of one solar cell is placed against the straight edge of another one of the solar cells. For example, the straight edges can be placed against each other where the mosaic elements adjoin. (See, e.g., FIG. 3E, 3G).

In some embodiments of the disclosure, the solar cells are arranged in a pattern formed by an array of rectangular unit cells, each unit cell encompassing an identical or substantially identical arrangement of at least two solar cells. This can be an advantage over the use of tightly packed solar cells having a circular shape, that is, shaped as substantially full circles. If one or more substantially fully circular solar cells are efficiently fitted into the area of a rectangle, the rectangle being a unit cell useful for building a rectangular array of unit cells, that is, with rows and columns of aligned unit cells, the fill factor will be relatively low (i.e., in the order of 60%), which is a disadvantage. If, on the other hand, the circular unit cells are placed as close together as possible, the unit cell will be hexagonal, which is a disadvantage for fitting neatly into a rectangular or substantially rectangular solar cell assembly comprising an array of unit cells. Contrarily, with the present disclosure, it is possible to obtain rectangular unit cells with a rather high fill factor, such as greater than 90%, which fit neatly into a rectangular or substantially rectangular solar cell assembly comprising an array of unit cells.

In some embodiments of the disclosure, each unit cell encompasses at least two solar cells arranged so that the curved edge of each one of said solar cells is placed against the curved edge of another one of said solar cells. This provides for a high fill factor of the unit cell and, accordingly, of a rectangular or substantially rectangular solar cell assembly made up of a row or array of unit cells, such as an array comprising rows and columns of unit cells.

In some embodiments of the invention, each unit cell encompasses at least two solar cells arranged so that a flat portion at a curved edge of one solar cell is placed against a flat portion at a curved edge of another one of said solar cells. These flat portions can in some embodiments of the invention originate from original flat portions of the wafer, or they can have been added by cropping the solar cells at their curved edges.

In some embodiments of the disclosure, the solar cells have been obtained by dividing a substantially circular wafer into a plurality of substantially identical portions, such as into substantially identical sectors. Thus, full advantage is taken of the material of the wafer, thereby minimizing the cost per area of solar cell. The use of identical portions can simplify the assembly. Preferably, at least the size of the portions is substantially the same, as this provides for substantially identical production of electrical current, which simplifies the interconnection of solar cells.

Some embodiments of the disclosure relate to a method of producing solar cells for a solar cell assembly, comprising the step of dividing at least one substantially circular solar cell wafer into a plurality of portions, each portion being a solar cell, at least some of said portions having at least one substantially straight edge and one substantially curved edge corresponding to an arc of the circumference of the solar cell wafer. In some embodiments of the disclosure, said portions are sectors of the circular solar cell wafer, for example quadrants or semicircles, as explained above.

Some embodiments of the disclosure relate to a method of producing a solar cell assembly, comprising the steps of providing a plurality of solar cells with the method described above, and assembling the solar cells to provide a substantially rectangular solar cell assembly.

In some embodiments of the disclosure, the method comprises the step of arranging the solar cells according to a pattern of identical rectangular unit cells arranged in an array forming the substantially rectangular solar cell assembly, each unit cell including an identical arrangement of at least two solar cells. In some embodiments of the disclosure, the solar cells are substantially identical. The use of substantially identical solar cells, or at least of solar cells having substantially the same effective surface area, often simplifies the interconnection of solar cells, as there is less need to take differences in electrical current production into account.

In some embodiments, the CIC includes an interconnection member (or "interconnect") which can be, for example, a thin metal plate. Useful metals include, for example, molybdenum; a nickel-cobalt ferrous alloy material designed to be compatible with the thermal expansion characteristics of borosilicate glass such as that available under the trade designation KOVAR from Carpenter Technology Corporation; a nickel iron alloy material having a uniquely low coefficient of thermal expansion available under the trade designation Invar, FeNi36, or 64FeNi; or the like.

Additional aspects, advantages, and novel features of the present disclosure will become apparent to those skilled in the art from this disclosure, including the following detailed description as well as by practice of the disclosure. While the disclosure is described below with reference to preferred embodiments, it should be understood that the disclosure is not limited thereto. Those of ordinary skill in the art having access to the teachings herein will recognize additional applications, modifications and embodiments in other fields, which are within the scope of the disclosure as disclosed and claimed herein and with respect to which the disclosure could be of utility.

### BRIEF DESCRIPTION OF THE DRAWINGS

To complete the description and in order to provide for a better understanding of the disclosure, a set of drawings is provided. Said drawings form an integral part of the description and illustrate embodiments of the disclosure, which should not be interpreted as restricting the scope of the disclosure, but just as examples of how the disclosure can be carried out. The drawings comprise the following figures:
Figure 1A illustrates a circular solar cell wafer from which three solar cells (mosaic elements) according to an example (not claimed) of the present disclosure are scribed;
Figure 1B illustrates a CIC assembly according to a first example (not claimed) of the present disclosure utilizing the three solar cells of FIG. 1A;
FIG. 2A illustrates an example (not claimed) of a circular solar cell wafer from which eight solar cells are scribed;
FIG. 2B illustrates a CIC assembly according to a second example (not claimed) embodiment of the present disclosure utilizing the eight solar cells of FIG. 2A;
FIG. 2C illustrates a CIC assembly similar to FIG. 1B using a single piece interconnect;
FIG. 2D illustrates a CIC assembly similar to FIG. 2B using a single piece interconnect;
FIG. 2E illustrates a CIC assembly derived from solar cells utilizing a plurality of wafers, and a single piece interconnect;
FIG. 3A schematically illustrates a circular solar cell wafer from which four solar cells are scribed, in accordance with an embodiment of the disclosure;
FIG. 3B schematically illustrates the assembly of a first unit cell from the wafer of FIG. 3A, according to a method within the scope of claim 1;
FIG. 3C schematically illustrates the assembly of a second unit cell from the wafer of FIG. 3A, according to a method within the scope of claim 1;
FIG. 3D schematically illustrates a circular solar cell wafer from which four solar cells are scribed, in accordance with another embodiment of the disclosure;
FIG. 3E schematically illustrates the assembly of another example (not claimed) of a unit cell utilizing four mosaic elements based on a quadrant of the wafer;
FIG. 3F schematically illustrates the assembly of another example (not claimed) of a unit cell utilizing three mosaic elements based on using two quadrants of the wafer, and a semicircle from the wafer;
FIG. 3G schematically illustrates the assembly of another example (not claimed) of a unit cell utilizing three mosaic elements based on using two quadrants of the wafer, and a semicircle from the wafer;
FIG. 4 is a cross-sectional view of the two adjacent CICs through the 4-4 plane shown in FIG. 3C; and
FIG. 5 is a graph which depicts the relation between the packing factor and the wafer utilization or amount of used wafer surface area for a given wafer for two mosaic assemblies according to the present disclosure, compared to a typical assembly with a 1-fer or 2-fer.

### DESCRIPTION OF THE PREFERRED EMBODIMENT

Details of the present invention will now be described including exemplary aspects and embodiments thereof. Referring to the drawings and the following description, like reference numbers are used to identify like or functionally similar elements, and are intended to illustrate major features of exemplary embodiments in a highly simplified diagrammatic manner. Moreover, the drawings are not intended to depict every feature of the actual embodiment nor the relative dimensions of the depicted elements, and are not drawn to scale.

A variety of different features of mosaic solar cell assemblies are disclosed in the related applications noted above. Some, many or all of such features may be included in the structures and fabrication processes associated with the solar cell assemblies of the present disclosure.

Figure 1A illustrates a circular solar cell wafer 100 from which three mosaic solar cell elements 101, 102, and 103 according to an example (not claimed) of the present disclosure are scribed. In the depicted example, the wafer 100 is a four-inch (or 100 mm diameter) wafer, and the area of the mosaic elements 101, and 102/103 are 50.63 cm² and 8.40 cm² respectively.

Figure 1B illustrates a portion of the CIC assembly 108 according to a first example (not claimed) of the present disclosure utilizing the three mosaic solar cell elements of FIG. 1A arranged into a rectangular reference template, with individual discrete interconnects 104, 105, 106 and 107 attached to the top edge of each of the mosaic solar cell element.

FIG. 2A illustrates a circular solar cell wafer 200 in a second example (not claimed) from which four mosaic solar cell elements are scribed; including two identical upper and lower solar cells 207, 208; two right and left solar cells 201, 202; and four center solar cells 203, 204, 205, 206. In a four inch 100 mm) wafer, the center mosaic solar cell elements are rectangular in shape with dimensions of 15 mm x 60 mm, or each having an area of 9 cm².

FIG. 2B illustrates a portion of a CIC assembly 210 according to a second example (not claimed) of the present disclosure utilizing the eight mosaic solar cell elements of FIG. 2A. Individual interconnects 251 are provided along the upper edge depicted in the Figure making electrical contact with the top surface of each of the mosaic elements 207, 201, 203, 204, 205, 206, 202 and 208.

FIG. 2C illustrates a portion of CIC assembly 220 similar to FIG. 1B using a single piece interconnect 252 making contact with each of the mosaic elements 207, 215, and 208.

FIG. 2D illustrates a portion of a CIC assembly 230 similar to FIG. 2B using a single piece interconnect 252 making contact with each of the mosaic elements 207, 201, 203, 204, 205, 206, 202 and 208.

FIG. 2E illustrates a portion of a CIC assembly derived from solar cells utilizing a plurality of wafers, and a single piece interconnect 252 making contact with each of the mosaic elements 207, 201, 203, 204, 207, 201, 205, 206, 211, 212, 202 and 208. (The cover glass of the CIC is omitted from FIGS. 1B and 2B through 2E for simplicity).

Figure 3A schematically illustrates how, in accordance with an embodiment of the disclosure within the scope of independent claim 1, a substantially circular solar cell wafer 300 is divided into four sectors (in the figure, the sectors are quadrants), thus producing four solar cells 301, 302, 303 and 304, in which 301 and 303 each have a curved edge 316 and 317 respectively, corresponding to the arc portion of the circumference of the circular wafer 300, and three substantially straight edges 312, 314 and 315, and 313, 314, 315 respectively extending at a right angle (90 degrees). Solar cells 302 and 304 each have four straight edges 310, 312, 314 and 315, and 311, 313, 214 and 315, respectively. These solar cells can be packed to form a solar cell assembly 320 or 330 as illustrated in FIG. 3B and 3C shaped as a rectangle, these rectangles being arranged adjacent to each other forming an array.

Each rectangle 320 or 330 encompasses two solar cells 301, 303 or 302, 304 respectively, fitting efficiently into the area of the rectangle or unit cell as shown in FIGS. 3B and 3C respectively. These unit cells can fill a rectangular panel or surface with a fill factor of 100%. Thus, the fill factor of the solar cells on the panel, that is, the fill factor of the solar cells 301, 303 and 302, 304 in the entire solar cell array, will be the same as the fill factor of the solar cells 301, 303 and 302, 304 in the unit cell.

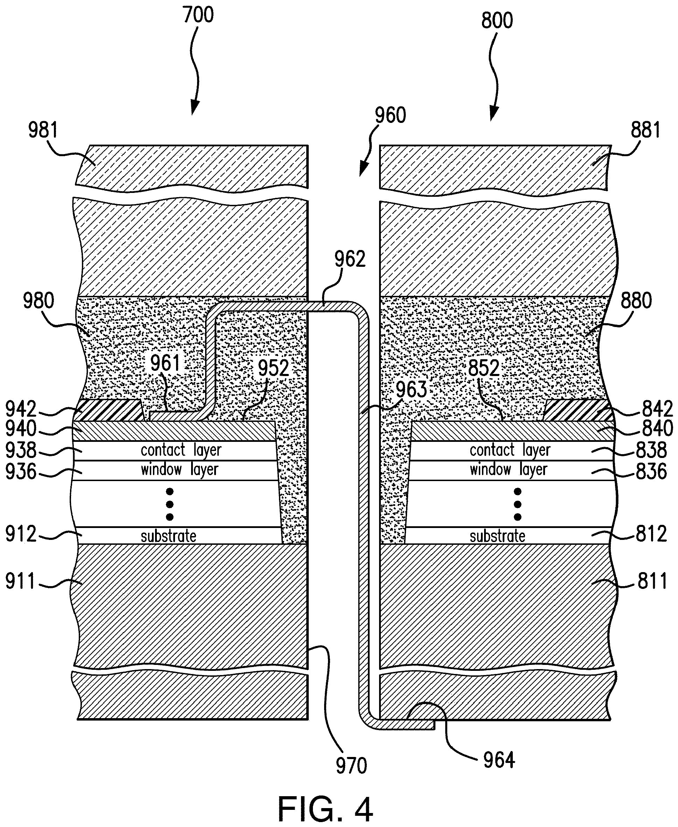

The sequence of steps for fabricating the CIC or mosaic solar cell assembly comprises the steps of: providing a circular solar cell wafer 300; chamfering at least one diametrically opposed pair of sides 310 and 311 of the wafer along two spaced apart portions of the circumference; cutting the wafer into four quadrants 301, 302, 303 and 304 to form mosaic elements; providing a cover glass support (cover glass 981 shown in FIG. 4); rearranging and positioning at least two mosaic elements adjacent to one another into a substantially rectangular mosaic assembly shown in FIG. 3B or FIG. 3C; providing a metal interconnect 341, 342 or 343, 344 to each of the mosaic elements so that the mosaic elements may be electrically connected to an adjacent mosaic assembly (CIC 700 being connected to CIC 800 as shown in FIG. 4); and bonding the cover glass support 981 to the top of the mosaic assembly.

It has been found that the use of solar cells shaped substantially as quadrants of a circle can at least sometimes be an appropriate solution, taking into account how the quadrants can fit into a rectangular unit cell with a fill factor of about 90% or greater, that is, with a rather high fill factor.

FIG. 3B schematically illustrates the assembly of a first embodiment of a mosaic assembly 320 from the wafer of FIG. 3A using the mosaic elements 301 and 303. Interconnects 341 and 342 are provided and mounted to the top surface of mosaic elements 303 and 301 respectively to make electrical contact with a bus bar (not shown) on the top surface thereof.

FIG. 3C schematically illustrates the assembly of a second embodiment of a mosaic assembly 330 from the wafer of FIG. 3A using the mosaic elements 302 and 304. Interconnects 343 and 344 are provided and mounted to the top surface of mosaic elements 302 and 303 respectively to make electrical contact with a bus bar (not shown) on the top surface thereof.

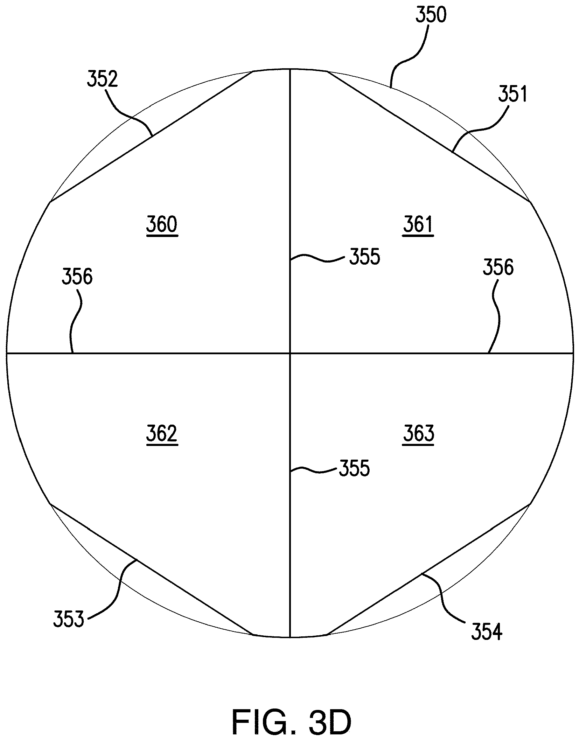

FIG. 3D schematically illustrates a circular solar cell wafer 350 from which four solar cell mosaic elements 360, 361, 362 and 363 are scribed, in accordance with another embodiment of the disclosure.

FIG. 3E schematically illustrates the assembly of an example (not claimed) of a mosaic assembly 370 from the wafer of FIG. 3D using the mosaic elements 371, 372, 373, and 374. Interconnects 375 are provided and mounted to the top surface of each of the mosaic elements 371, 372, 373 and 374 respectively to make electrical contact with a bus bar (not shown) on the top surface thereof.

FIG. 3F schematically illustrates the assembly of an example (not claimed) of a mosaic assembly 380 from the wafer of FIG. 3D using the mosaic elements 381, 382, and 383. Interconnects 385 are provided and mounted to the top surface of mosaic elements 381, 382,and 383 respectively to make electrical contact with a bus bar (not shown) on the top surface thereof.

FIG. 3G schematically illustrates the assembly of an example (not claimed) of a mosaic assembly 390 from the wafer of FIG. 3D using the mosaic elements 391, 392 and 393. Interconnects 395 are provided and mounted to the top surface of mosaic elements 391, 392 and 393 respectively to make electrical contact with a bus bar (not shown) on the top surface thereof.

FIG. 4 is a cross-sectional view of the CICs of FIG. 3C after the next process step of alignment of the CIC 700 with the edge of an adjacent CIC 800, in the process of fabricating an interconnected array or string of solar cells. Several strings may then be arranged in parallel to form an array. The solar cell of similar CIC 800 includes layers 811, 812 through 836, 838, and 840 similar to layers 911, 912, ... through 936, 938, and 940 respectively of a solar cell of CIC 700. A cover glass 881 is attached by adhesive 880 to the solar cell 800 similar to that of the cover glass 981 in solar cell 300. The composition of the solar cell layers are described more fully in the related applications incorporated herein by reference.

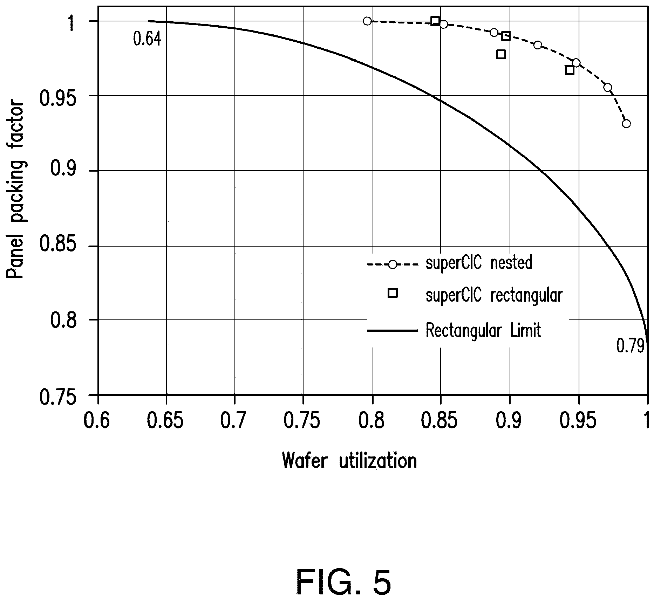

FIG. 5 is a graph which depicts the relation between the packing factor and the wafer utilization or amount of used wafer surface area for a given wafer for two mosaic assemblies according to the present disclosure, compared to a typical assembly with a 1-fer or 2-fer solar cell (labelled "Rectangular Limit"). The circular references refer to the assemblies of FIG. 3B or 3C, while the square references refer to the assemblies of FIGS. 2B, 2C, 2D or 2E.

The packing factor referred to in this document is generally the local packing factor, which in many embodiments can differ from the overall packing factor of the solar cell assembly, for example due to a lower local packing factor in correspondence with the edges of the assembly (for example, due to the size and/or shape of the assembly), and/or due to the presence of other components on the solar cell assembly.

In this specification, the term "solar cell" or "solar cell mosaic element" refers to a solar cell, or simply "mosaic element", that is an integral portion of a solar cell wafer, rather than a solar cell made up of a plurality of interconnected portions.

References to rows and columns of an array do not imply any specific orientation of the rows and columns, for example, rows are not necessarily oriented horizontally and columns are not necessarily orientated vertically. Rather, the references to rows and columns refer to solar cells arranged in a more or less regular pattern, wherein groups of solar cells can be identified in which the solar cells are arranged after each other. A group of solar cells in which the solar cells are arranged after each other in one direction can be considered a row, and a group of solar cells in which the solar cells are arranged after each other in a different direction can be regarded a column.

In this text, the term "comprises" and its derivations (such as "comprising", etc.) should not be understood in an excluding sense, that is, these terms should not be interpreted as excluding the possibility that what is described and defined may include further elements, steps, etc.

The disclosure is not limited to the specific embodiment(s) described herein, but also encompasses any variations that may be considered by any person skilled in the art (for example, as regards the choice of materials, dimensions, components, configuration, etc.), within the general scope of the disclosure as defined in the claims.

## Claims

1. A method of producing a solar cell assembly (320; 330) comprising the steps of:
providing at least one solar cell wafer (300);
cutting each wafer into a plurality of mosaic elements (301, 302, 303, 304);
arranging a plurality of the mosaic elements one after the other along a first axis, so that the mosaic elements form a row of mosaic elements, each mosaic element having substantially the same height in a direction perpendicular to the first axis, each mosaic element having a first end at a first distance from the first axis and a second end at a second distance from the first axis, in the direction perpendicular to the first axis;
providing each mosaic element with a conductive interconnect (341, 342; 343, 344) at the first end thereof, so that the solar cell assembly can be electrically connected to an adjacent solar cell assembly; and
bonding the mosaic elements to a cover glass (881, 981);
wherein the method comprises the steps of:
chamfering at least one diametrically opposed pair of sides of the wafer (300) along two spaced apart portions of the circumference;
cutting the wafer into four quadrants to form mosaic elements (301, 302, 303, 304);
rearranging and positioning at least two mosaic elements adjacent to one another into a substantially rectangular mosaic assembly (320, 330);
wherein
two of the mosaic elements are arranged so that the curved edge of each one of said mosaic elements (301) is placed adjacent to and against the curved edge of another one of said mosaic elements (303), and the straight line cuts producing the four quadrants comprise the right and left sides of a rectangular reference template,
and wherein two other ones of the mosaic elements (302, 304) are arranged and positioned with the straight chamfer cut on each element being positioned directly adjacent one another to form the mosaic assembly.

2. The method according to claim 1, wherein each of the chamfer cuts on opposed sides of the circular wafer are the same length.

3. The method according to claim 1 or 2, wherein two of the mosaic elements (301, 303) are identical in shape, and the other two mosaic elements (302, 304) are identical in shape, but different from the first two mosaic elements.

4. The method according to any one of the preceding claims, wherein the mosaic solar cell elements are mounted on the cover glass support forming a rectangular reference template with each element having the same height and arranged serially along the length of the rectangular template, and an interconnect being mounted on the upper edge of each mosaic element, so that the set of interconnects are arranged along one side of the solar cell assembly.

5. The method according to any one of the preceding claims, wherein the interconnects comprise a single integral interconnect element (252) with discrete toes connected to each mosaic element.

6. The method according to any one of the preceding claims, wherein the step of bonding the mosaic elements to a cover glass (881, 981) comprises bonding the mosaic elements of the assembly to a single cover glass support covering all of the mosaic elements of the assembly;

7. The method according to any one of the preceding claims, wherein the at least one wafer is a III-V compound semiconductor solar cell wafer

8. The method according to any one of the preceding claims, wherein each of the two of the mosaic elements that are arranged so that the curved edge of each one of said mosaic elements (301) is placed adjacent to and against the curved edge of another one of said mosaic elements (303), have a straight edge in correspondence with its first end and another straight edge in correspondence with its second end.

## Patentansprüche

1. Verfahren zur Herstellung einer Solarzellenanordnung (320; 330), das die folgenden Schritte umfasst:
Bereitstellen mindestens eines Solarzellenwafers (300);
Schneiden jedes Wafers in eine Vielzahl von Mosaikelementen (301, 302, 303, 304);
Anordnen einer Vielzahl der Mosaikelemente nacheinander entlang einer ersten Achse, so dass die Mosaikelemente eine Reihe von Mosaikelementen bilden, wobei jedes Mosaikelement im Wesentlichen die gleiche Höhe in einer Richtung senkrecht zur ersten Achse aufweist, wobei jedes Mosaikelement ein erstes Ende in einem ersten Abstand von der ersten Achse und ein zweites Ende in einem zweiten Abstand von der ersten Achse in der Richtung senkrecht zur ersten Achse aufweist;
Bestückung jedes Mosaikelements mit einer leitenden Zwischenverbindung (341, 342; 343, 344) an dessen erstem Ende, so dass die Solarzellenanordnung elektrisch mit einer benachbarten Solarzellenanordnung verbunden werden kann; und
Verbinden der Mosaikelemente mit einem Deckglas (881, 981);
wobei das Verfahren die folgenden Schritte umfasst:
Fasen mindestens eines diametral gegenüberliegenden Paares von Seiten des Wafers (300) entlang zweier beabstandeter Abschnitte des Umfangs;
Schneiden des Wafers in vier Quadranten, um Mosaikelemente (301, 302, 303, 304) zu bilden;
Umordnen und Positionieren mindestens zweier aneinander angrenzender Mosaikelemente in eine im Wesentlichen rechteckige Mosaikanordnung (320, 330);
wobei
zwei der Mosaikelemente so angeordnet werden, dass die gekrümmte Kante jedes der Mosaikelemente (301) angrenzend an und gegen die gekrümmte Kante eines anderen der Mosaikelemente (303) platziert wird, und die geraden Schnitte, die die vier Quadranten erzeugen, die rechte und die linke Seite einer rechteckigen Referenzvorlage umfassen,
und wobei zwei andere der Mosaikelemente (302, 304) angeordnet und positioniert werden, wobei der gerade Fasenschnitt an jedem Element direkt aneinander angrenzend positioniert wird, um die Mosaikanordnung zu bilden.

2. Verfahren nach Anspruch 1, wobei jeder der Fasenschnitte auf gegenüberliegenden Seiten des kreisförmigen Wafers gleich lang ist.

3. Verfahren nach Anspruch 1 oder 2, wobei zwei der Mosaikelemente (301, 303) in ihrer Form identisch sind und die anderen beiden Mosaikelemente (302, 304) in ihrer Form identisch sind, sich aber von den ersten beiden Mosaikelementen unterscheiden.

4. Verfahren nach einem der vorhergehenden Ansprüche, wobei die Mosaik-Solarzellenelemente auf dem Deckglasträger montiert sind und eine rechteckige Referenzvorlage bilden, wobei jedes Element die gleiche Höhe aufweist und seriell entlang der Länge der rechteckigen Vorlage angeordnet ist, und wobei eine Zwischenverbindung an der oberen Kante jedes Mosaikelements montiert ist, so dass die Gruppe von Zwischenverbindungen entlang einer Seite der Solarzellenanordnung angeordnet ist.

5. Verfahren nach einem der vorhergehenden Ansprüche, wobei die Verbindungen ein einzelnes integrales Zwischenverbindungselement (252) mit einzelnen Zehen umfassen, die mit jedem Mosaikelement verbunden sind.

6. Verfahren nach einem der vorhergehenden Ansprüche, wobei der Schritt des Verbindens der Mosaikelemente mit einem Deckglas (881, 981) das Verbinden der Mosaikelemente der Anordnung mit einem einzelnen Deckglasträger umfasst, der alle Mosaikelemente der Anordnung bedeckt;

7. Verfahren nach einem der vorstehenden Ansprüche, wobei der mindestens eine Wafer ein III-V-Verbindungshalbleiter-Solarzellenwafer ist.

8. Verfahren nach einem der vorhergehenden Ansprüche, wobei jedes der zwei Mosaikelemente, die so angeordnet sind, dass die gekrümmte Kante jedes der Mosaikelemente (301) angrenzend an und gegen die gekrümmte Kante eines anderen der Mosaikelemente (303) platziert ist, eine gerade Kante in Übereinstimmung mit seinem ersten Ende und eine weitere gerade Kante in Übereinstimmung mit seinem zweiten Ende aufweist.

## Revendications

1. Méthode pour produire un ensemble de cellules solaires (320; 330) comprenant les étapes consistant à :
fournir au moins une plaquette de cellule solaire (300) ;
couper chaque plaquette en une pluralité d'éléments de mosaïque (301, 302, 303, 304) ;
agencer une pluralité d'éléments de mosaïque les uns après les autres le long d'un premier axe, de sorte que les éléments de mosaïque forment une rangée d'éléments de mosaïque, chaque élément de mosaïque ayant sensiblement la même hauteur dans une direction perpendiculaire au premier axe, chaque élément de mosaïque ayant une première extrémité à une première distance du premier axe et une seconde extrémité à une seconde distance du premier axe, dans une direction perpendiculaire au premier axe ;
doter chaque élément de mosaïque d'une interconnexion conductrice (341, 342 ; 343, 344) au niveau de sa première extrémité, de sorte que l'ensemble de cellules solaires peut être raccordé électriquement à un ensemble de cellules solaires adjacent ; et
relier les éléments de mosaïque à un verre de recouvrement (881, 981) ;
dans laquelle la méthode comprend les étapes consistant à :
chanfreiner au moins une paire diamétralement opposée de côtés de la plaquette (300) le long de deux parties espacées de la circonférence ;
couper la plaquette en quatre quadrants afin de former des éléments de mosaïque (301, 302 ; 303, 304) ;
réagencer et positionner au moins deux éléments de mosaïque adjacents l'un par rapport à l'autre en un ensemble de mosaïque sensiblement rectangulaire (320, 330) ;
dans laquelle :
deux des éléments de mosaïque sont agencés de sorte que le bord courbé de chacun desdits éléments de mosaïque (301) est placé de manière adjacente à et contre le bord courbé d'un autre desdits éléments de mosaïque (303), et les coupes en ligne droite produisant les quatre quadrants comprennent les côtés droit et gauche d'un modèle de référence rectangulaire,
et dans laquelle deux autres des éléments de mosaïque (302, 304) sont agencés et positionnés avec la coupe chanfrein droite sur chaque élément qui est positionné de manière directement adjacente à l'autre afin de former l'ensemble de mosaïque.

2. Méthode selon la revendication 1, dans laquelle chacune des coupes chanfrein sur les côtés opposés de la plaquette circulaire ont la même longueur.

3. Méthode selon la revendication 1 ou 2, dans laquelle deux des éléments de mosaïque (301, 303) ont une forme identique, et les deux autres éléments de mosaïque (302, 304) ont une forme identique, mais différente des deux premiers éléments de mosaïque.

4. Méthode selon l'une quelconque des revendications précédentes, dans laquelle les éléments de cellule solaire de mosaïque sont montés sur le support de verre de recouvrement formant un modèle de référence rectangulaire avec chaque élément ayant la même hauteur et agencé en série le long de la longueur du modèle rectangulaire, et une interconnexion étant montée sur le bord supérieur de chaque élément de mosaïque, de sorte que l'ensemble d'interconnexions est agencé le long d'un côté de l'ensemble de cellules solaires.

5. Méthode selon l'une quelconque des revendications précédentes, dans laquelle les interconnexions comprennent un élément d'interconnexion solidaire (252) unique avec des pointes discrètes connectées à chaque élément de mosaïque.

6. Méthode selon l'une quelconque des revendications précédentes, dans laquelle l'étape consistant à relier les éléments de mosaïque à un verre de recouvrement (881, 981) comprend l'étape consistant à relier les éléments de mosaïque de l'ensemble à un support de verre de recouvrement unique recouvrant la totalité des éléments de mosaïque de l'ensemble.

7. Méthode selon l'une quelconque des revendications précédentes, dans laquelle la au moins une plaquette est une plaquette de cellule solaire à semi-conducteur composé du groupe III-V.

8. Méthode selon l'une quelconque des revendications précédentes, dans laquelle chacun des deux des éléments de mosaïque qui sont agencés de sorte que le bord courbé de chacun desdits éléments de mosaïque (301) est placé de manière adjacente à et contre le bord courbé d'un autre desdits éléments de mosaïque (303), a un bord droit en correspondance avec sa première extrémité et un autre bord droit en correspondance avec sa seconde extrémité.
